Europäisches Patentamt

European Patent Office

Office européen des brevets

(11) Publication number: **0 107 906**
**B1**

# EUROPEAN PATENT SPECIFICATION

(45) Date of publication of patent specification: **06.05.87**     (51) Int. Cl.⁴: **H 01 L 23/32, H 05 K 7/10**

(21) Application number: **83305575.9**

(22) Date of filing: **21.09.83**

(54) Socket for integrated circuit.

(30) Priority: **29.09.82 JP 168276/82**

(43) Date of publication of application:
**09.05.84 Bulletin 84/19**

(45) Publication of the grant of the patent:
**06.05.87 Bulletin 87/19**

(84) Designated Contracting States:
**DE FR GB**

(56) References cited:
**EP-A-0 030 763**
**FR-A-2 392 575**
**US-A-4 331 373**

**COMPUTER, vol. 10, no. 12, December 1977,**
**Long Beach J.W. BALDE et al. "New chip carrier**
**package concepts", pages 58-68**

(73) Proprietor: **FUJITSU LIMITED**
**1015, Kamikodanaka Nakahara-ku**
**Kawasaki-shi Kanagawa 211 (JP)**

(72) Inventor: **Yoshizaki, Tsutomu**
**2-20, Oppama Higashi-cho**
**Yokosuka-shi Kanagawa 237 (JP)**
Inventor: **Ishii, Toshimasa**
**25-2, Miyagaya Nishi-ku**
**Yokohama-shi Kanagawa 211 (JP)**

(74) Representative: **George, Sidney Arthur et al**
**GILL JENNINGS & EVERY 53-64 Chancery Lane**
**London WC2A 1HN (GB)**

Courier Press, Leamington Spa, England.

## Description

This invention relates to a socket for receiving an integrated circuit (IC) device.

An IC socket is used for receiving an IC device such as a leadless chip carrier (LCC) when the IC device is burn-in tested and checked by various characteristic methods. An IC socket is mounted on a printed circuit board and is connected to circuit patterns formed thereon for testing the IC device.

An IC socket is also used in various electronic circuits in which some of the IC devices thereof are demountably installed in IC sockets, instead of being directly mounted on a printed circuit board and secured thereto, so that the IC devices can be easily removed and replaced with other IC devices.

The above-mentioned IC socket is box-shaped, with its upper side open. The IC device is inserted into the IC socket through the opening and is housed therein. A plurality of contacts corresponding to the electrodes of the IC device to be received are provided in the IC socket.

The electrodes of the LCC are formed on the four side surfaces of the block-shaped LCC, the lower end of each electrode slightly extending on to the bottom surface. The contacts of the conventional IC socket are disposed on the side walls of the box-shaped IC socket and resiliently press the LCC from all four sides so as to retain the LCC and to make contact with the electrodes formed on the side faces of the LCC. This type of conventional IC socket is large, since its contacts are disposed round the periphery of the LCC to be housed therein. Such a large IC socket is not suitable when it is desired to mount a plurality of LCCs compactly on a printed board. Also, the conventional IC socket is less manipulatable when the number of contacts is increased, since an increased number of contacts increases the resistance to insertion of and removal of the LCC (see EP—A—0030763).

It is a purpose of the present invention to provide an IC socket which is compact, which has a simple construction, and which can be easily manipulated.

In accordance with the present invention there is provided a socket for a leadless chip carrier integrated circuit (IC) device of quadrilateral plan, which device has a plurality of electrodes formed on its bottom surface, the socket comprising a box-shaped housing of dielectric material which is open at an upper side and has a recess of quadrilateral plan for receiving the IC device, and a plurality of contacts for making contact with the electrodes of the IC device within the recess, each of the contacts comprising a resilient conductive member and being disposed in the bottom of the housing so as to make contact with the electrodes formed on the bottom surface of the IC device; characterised in that two pairs of pressure members for holding the IC device are disposed within the recess, each pressure member being formed as one body integral with the housing and comprising a resilient portion extending substantially vertically in the recess with an inwardly-projecting rounded projection formed at a top end of the resilient portion for pressing the IC device, the two pairs of pressure members being arranged at the sides of the socket at two diagonally-opposed corners of the recess so that a pressure member of each pair engages with a different side edge of the IC device at two diagonally-opposed corners, while the other two diagonally-opposed corners of the recess are not provided with pressure members, whereby the edges of the IC device at said other corners are accessible for withdrawal of the IC device from the recess against force exerted by the pressure members.

An embodiment of the invention will now be described, by way of example, with reference to the accompanying drawings, in which:

Figure 1 is a perspective view of a socket according to the present invention and an IC device, to be inserted therein;

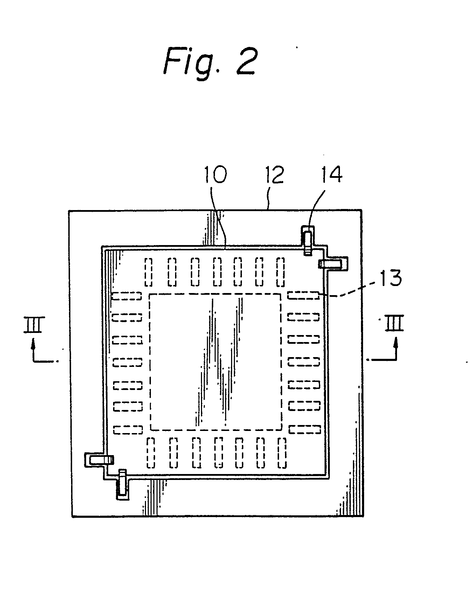

Figure 2 is a plan view of the socket of Figure 1;

Figure 3 is a sectional view of the socket taken along a line III—III of Figure 2; and

Figure 4 is a sectional view of another IC socket according to the present invention.

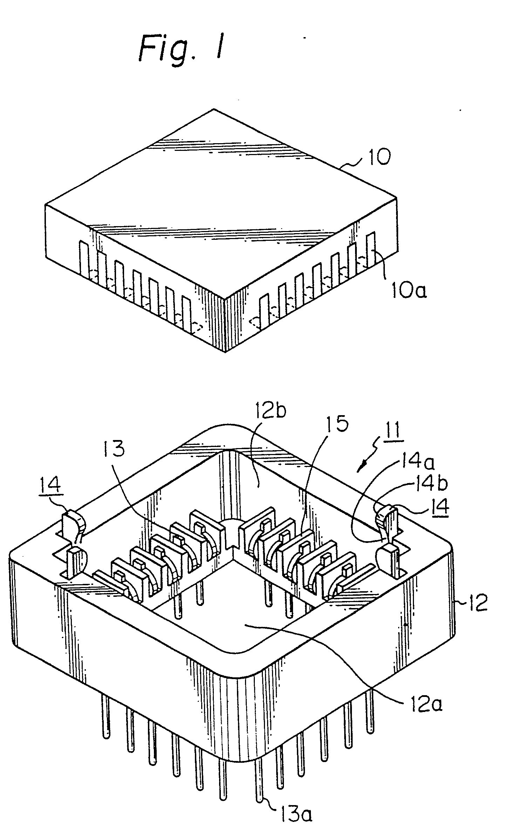

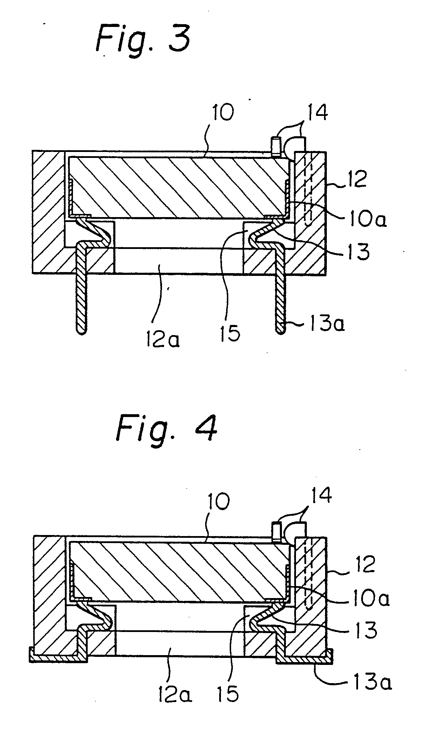

Referring to Fig. 1 of the drawings, an LCC-type IC device 10 has a plurality of electrodes 10a disposed on its four side faces. The lower end of each electrode 10a extends on to the bottom face of the IC device 10. An IC socket 11 of the present invention comprises a box-shaped housing 12 of dielectric material which is open at its upper side and has a recess 12b for receiving the IC device 10. A plurality of contacts 13 make contact with the electrodes 10a of the IC device 10 from the bottom thereof. Two pairs of pressure members 14 are provided for retaining the IC device 10 within the housing 12. Each contact 13 has a curved portion at its inner end so as to make the contact springy, as illustrated in Figs. 1 and 3. The upper end of each contact 13 makes contact with the portion of a respective electrode 10a formed on the bottom face of the IC device 10. The lower end of each contact 13 constitutes a lead terminal 13a for attaching the socket 11 to a printed circuit board (not shown). The contacts 13 are integrated with the housing 12 by an insert-moulding process, with the lead terminals 13a projecting out of the housing 12. The arrangement of the contacts 13 corresponds to the arrangement of the electrodes 10a of the IC device 10.

The pressure members 14 are formed integrally with the housing 12. Each pressure member 14 comprises a springy portion 14a and a semicircular-shaped projection 14b formed at the top end of the springy portion. As the IC device 10 is being inserted into the recess 12b of the housing 12, the device abuts against the projections 14b of the pressure members 14, and the projections are resiliently pushed outwards. When the IC device 10 has been inserted into the recess 12b, the pressure members 14 spring back into place so that the projections 14b press against the upper surface of the IC device 10 and urge the device

2

downwards against the upward spring force of the contacts 13 and retain the IC device within the housing 12. Each contact 13 is separated from the adjacent contacts by a partition 15.

An opening 12a is formed in the bottom of the housing 12. If it is necessary to remove the IC device 10 from the housing 12 before the socket 11 is secured to the printed board, the device 10 can be easily removed by applying pressure to its bottom face through the opening 12a.

The IC socket 11 is mounted on the printed board by inserting the lead terminals 13a into through-holes of the board and soldering them thereto.

The lead terminal 13a of each contact 13 may be folded so as to be disposed on the lower surface of the housing 12 in contact with the housing, as illustrated in Fig. 4, instead of projecting downward out of the housing 12, as illustrated in Fig. 3. A socket provided with such folded lead terminals 13a is mounted on the printed circuit board in such a manner that the folded lead terminals 13a are disposed on, and are directly soldered to, the circuit pattern formed on the printed board without using through-holes in the printed board. The IC socket of Fig. 4 can be mounted on the upper surface of a large IC device having circuit patterns formed thereon instead of being mounted on a printed board.

In accordance with the present invention, it is possible to make the IC socket small, since the contacts 13 are disposed in the bottom of the socket, so as to contact the IC device from the bottom instead of round its periphery. The resistance to insertion of the IC device into the socket, which is the sum of the spring force of the contacts 13 and the spring force of the pressure members 14, is very small as compared with the prior art, in which the contacts are disposed round the periphery of the IC device so as to contact the side faces of the IC device. The resistance to withdrawal of the IC device from the socket is also small, since it is due only to the spring force of the pressure members 14. Therefore, the IC device can be easily inserted and withdrawn.

### Claims

1. A socket for a leadless chip carrier integrated circuit (IC) device (10) of quadrilateral plan, which device has a plurality of electrodes (10a) formed on its bottom surface, the socket comprising a box-shaped housing (12) of dielectric material which is open at an upper side and has a recess (12b) of quadrilateral plan for receiving the IC device, and a plurality of contacts (13) for making contact with the electrodes of the IC device within the recess, each of the contacts (13) comprising a resilient conductive member and being disposed in the bottom of the housing so as to make contact with the electrodes formed on the bottom surface of the IC device; characterised in that two pairs of pressure members (14) for holding the IC device are disposed within the recess, each pressure member being formed as one body integral with the housing and comprising a resilient portion (14a) extending substantially vertically in the recess with an inwardly-projecting rounded projection (14b) formed at a top end of the resilient portion for pressing the IC device, the two pairs of pressure members being arranged at the sides of the socket at two diagonally-opposed corners of the recess so that a pressure member of each pair engages with a different side edge of the IC device at two diagonally-opposed corners, while the other two diagonally-opposed corners of the recess are not provided with pressure members, whereby the edges of the IC device at said other corners are accessible for withdrawal of the IC device from the recess against force exerted by the pressure members.

2. A socket as claimed in claim 1, characterised in that the housing (12) has a respective partition (15) of dielectric material disposed between each two adjacent contacts (13).

3. A socket as claimed in claim 1 or claim 2, characterised in that the housing (12) has an opening (12a) formed in its bottom wall.

4. A socket as claimed in any preceding claim, characterised in that the end (13a) of each contact (13) constitutes a lead terminal which projects outwards from the bottom face of the housing (12).

5. A socket as claimed in any one of claims 1—3, characterised in that the end (13a) of each contact (13) constitutes a lead terminal which is folded so as to be disposed on the outside of the bottom wall of the housing (12) and in contact with the housing.

### Patentansprüche

1. Fassung für eine integrierte Schaltungsvorrichtung (IC) (10) von vierseitigem Grundriß mit einem leitungslosen Chipträger, welche Vorrichtung eine Vielzahl von an ihrer Unterseite ausgebildeten Elektroden (10a) hat, wobei die Fassung ein kastenförmiges Gehäuse (12) aus dielektrischem Material umfaßt, welches an einer Oberseite offen ist und eine Ausnehmung (12b) von vierseitigem Grundriß zur Aufnahme der IC-Vorrichtung hat, und eine Vielzahl von Kontakten (13), zur Kontaktierung der Elektroden der IC-Vorrichtung innerhalb der Ausnehmung, wobei jeder der Kontakte (13) ein elastisches leitendes Teil hat und in dem Boden des Gehäuses so angeordnet ist, daß er mit der Elektrode, die an der unteren Oberfläche der IC-Vorrichtung ausgebildet ist, in Kontakt kommt; dadurch gekennzeichnet, daß zwei Paare von Druckteilen (14) innerhalb der Ausnehmung angeordnet sind, um die IC-Vorrichtung zu halten, wobei jedes Druckteil als ein Körper einstückig mit dem Gehäuse geformt ist, und einen elastischen Abschnitt (14a) umfaßt, der sich im wesentlichen vertikal in der Ausnehmung erstreckt, mit nach innen vorstehendem, abgerundetem Vorsprung (14b), der an dem oberen Ende des elastischen Abschnittes gebildet ist, um die IC-Vorrichtung zu drücken, wobei die beiden Paare von Druckteilen an den Seiten der Fassung an zwei diagonal gegenüberliegenden Ecken der Ausnehmung so ausgebildet sind, daß ein Druckteil jedes Paares mit einer verschiedenen Seitenkante der IC-Vorrichtung an zwei diagonal gegenüberliegenden Ecken zum Eingriff kommt, während die anderen beiden diagonal gegenüberliegenden Ecken der Ausnehmung keine Druckteile aufweisen, wodurch die Kanten der IC-Vorrichtung an den genannten anderen Ecken zugänglich sind, um die IC-Vorrichtung gegen die durch die Druckteile ausgeübte Kraft aus der Ausnehmung herauszuziehen.

2. Fassung nach Anspruch 1, dadurch gekennzeichnet, daß das Gehäuse (12) zwischen je zwei benachbarten Kontakten (13) eine entsprechende Trennwand (15) aus dielektrischem Material aufweist.

3. Fassung nach Anspruch 1 oder 2, dadurch gekennzeichnet, daß das Gehäuse (12) eine Öffnung (12a) hat, die in seiner Unterseite ausgebildet ist.

4. Fassung nach einem der vorhergehenden Ansprüche, dadurch gekennzeichnet, daß das Ende (13a) von jedem Kontakt (13) einen Leitungsanschluß bildet, der von der Unterseite des Gehäuses (12) nach außen vorsteht.

5. Fassung nach einem der Ansprüche 1 bis 3, dadurch gekennzeichnet, daß das Ende (13a) von jedem Kontakt (13) einen Leitungsanschluß bildet, der so gefaltet ist, daß er an der Außenseite der Unterseite des Gehäuses (12) angeordnet und mit dem Gehäuse in Kontakt ist.

**Revendications**

1. Support pour un dispositif de circuit intégré (10) à support intermédiaire monté en surface, ayant, vu en plan, une forme de quadrilatère et possédant une pluralité d'électrodes (10a) formées sur sa surface inférieure, le support comportant un boîtier (12) en forme de boîte, en matière diélectrique, qui possède un côté supérieur ouvert et comporte un évidement (12b) ayant, vu en plan, une forme de quadrilatère, pour recevoir le dispositif de circuit intégré, ledit support comportant en outre une pluralité de contacts (13) destinés à venir au contact des électrodes du dispositif de circuit intégré, à l'intérieur de l'évidement, chacun de ces contacts (13) comportant un élément conducteur déformable élastiquement et étant disposé dans le fond du boîtier de manière à venir au contact des électrodes formées sur la surface inférieure du dispositif de circuit intégré; caractérisé en ce que deux paires d'organes presseurs (14) pour maintenir le dispositif de circuit intégré sont disposées dans l'évidement, chaque organe presseur étant réalisé sous la forme d'un corps d'un seul tenant avec le boîtier et comportant une partie déformable élastiquement (14a) qui s'étend sensiblement verticalement dans l'évidement et qui possède un relief arrondi (14b), formant saillie vers l'intérieur, formé sur une extrémité supérieure de cette partie déformable élastiquement, pour exercer une pression sur le dispositif de circuit intégré, les deux paires d'organes presseurs étant agencées sur les côtés du support, en deux coins diagonalement opposés de l'évidement, de manière qu'un organe presseur de chaque paire vienne en condition d'engagement avec un bord latéral différent du dispositif de circuit intégré, en deux coins diagonalement opposées, les deux autres coins diagonalement opposés de l'évidement n'étant pas pourvus d'organes presseurs, ce grâce à quoi les bords du dispositif de circuit intégré auxdits autres coins sont accessibles pour extraire le dispositif de circuit intégré de l'évidement, contre la force exercée par les organes presseurs.

2. Support selon la revendication 1, caractérisé en ce que le boîtier (12) possède des cloisons (15) en matière diélectrique disposées chacune entre deux contacts voisins (13).

3. Support selon la revendication 1 ou la revendication 2, caractérisé en ce que le boîtier (12) possède une ouverture (12a) formée dans sa paroi inférieure.

4. Support selon l'une quelconque des revendications précédentes, caractérisé en ce que l'extrémité (13a) de chaque contact (13) constitue un conducteur de raccordement qui déborde, en saillie vers l'extérieur, de la face inférieure du boîtier (12).

5. Support selon l'une quelconque des revendications 1 à 3, caractérisé en ce que l'extrémité (13a) de chaque contact (13) constitue un conducteur de raccordement qui est plié de manière à être disposé sur le côté extérieur de la paroi inférieure du boîtier (12) et à se trouver au contact de ce dernier.

# Fig. 1

# Fig. 2

# Fig. 3

# Fig. 4